# EUROPEAN PATENT APPLICATION

(11) **EP 2 503 595 A1**
(43) Date of publication of application: **26.09.2012**
(21) Application number: 12153710.4
(22) Date of filing: 02.02.2012
(51) Int. Cl.: H01L 23/62, H01L 25/07

(54) **Power semiconductor module and method of manufacturing a power semiconductor module**

(30) Priority: 18.02.2011 EP 11154920
(71) Applicant: ABB Research Ltd., 8050 Zürich (CH)
(72) Inventor: Liu, Chunlei, 5406 Rütihof (CH); Schulz, Nicola, 5300 Turgi (CH); Kicin, Slavo, 8049 Zürich (CH)
(74) Representative: ABB Patent Attorneys

(57) **Abstract**

The present invention relates to a power semiconductor module comprising a semiconductor device (12), in particular an insulated gate bipolar transistor, a reverse conductive insulated gate bipolar transistor, or a bi-mode insulated gate transistor, with an emitter electrode and a collector electrode, wherein an electrically conductive upper layer (14) is sintered to the emitter electrode, the upper layer (14) at least partly being capable of forming an eutecticum with the semiconductor of the semiconductor device (12) and at least partly having a coefficient of thermal expansion which differs from the coefficient of thermal expansion of the semiconductor in a range of ≤ 250%, in particular ≤ 50%, and wherein an electrically conductive base plate (20) is sintered to the collector electrode, and wherein the semiconductor module (10) further comprises an electrically conductive area (24) being electrically isolated from the base plate (20) and being connected to the upper layer (14) via a direct electrical connection (22). A semiconductor module according to the invention is easy to prepare, has an improved reliability and exhibits short circuit failure mode capacity.

## Description

### Technical Field

The Invention relates to a power semiconductor module and to a method of manufacturing a power semiconductor module. In particular, the invention relates to a power semiconductor module with a short circuit failure mode capability and to a method of manufacturing a power semiconductor module with a short circuit failure mode capability.

### Background Art

In the case of high power semiconductor modules used for example in serially connected stacks of such modules in HVDC applications and the like, it has been found that a defect leads to a short circuit. With large chip areas, this short circuit remains stable over a long time. If, for example, redundant thyristors are provided in a stack of thyristors connected in series, the remaining, intact thyristors withstand the voltage during the switched-off phase, and the stack remains operative. Defective thyristors can be replaced subsequently in the course of planned servicing work.

In a thyristor module, for example, the semiconductor, that is to say the silicon, is in mechanical and electrical contact with and arranged between two molybdenum wafers. Silicon (Si) has a melting point of 1420°C, wherein that of molybdenum (Mo) is higher, and the intermetallic compounds of silicon and molybdenum have a still higher melting point. Thus, in the event of a defect, the silicon melts locally first and, as current flows, it forms a conductive channel composed of molten Si over the entire thickness of the semiconductor. This defect zone can propagate and/or move, but will only affect a small part of the chip area. In hermetically sealed housings, the molten Si does not oxidize but reacts with molybdenum to form a type of powder. This process continues until all the Si has been consumed, and may possibly extend over years.

In contrast to thyristor semiconductor components, insulated gate bipolar transistor chips, for example, are not produced as large-area units and, therefore normally, a plurality of small-area individual chips are arranged isolated and alongside one another in the insulated gate bipolar transistor modules. Typically chip size of a small-area chip is between 0.25cm² to 10 cm². Today's thyristors, which are an example of a large-area unit, have a typical sizes of 10 cm² to 300 cm².

It has been found that no long-term stable short circuits of the type described above can be expected with insulated gate bipolar transistor modules, for example. This is primarily due to the reduced area of the individual chips, and the small silicon volume. The pseudo-stable phase of a short circuit lasts for only a few hours to days in this case. Furthermore, the housings are often deliberately not hermetically sealed, so that the molten silicon can react with oxygen and form insulating silica (SiO₂). Without any stable short-circuit path in the defective chip, the worst-case situation which can arise is as follows: If the remaining chips in a module, including the actuation, are still intact, they can withstand voltage during the switched-off phase. The current is then forced through the defective chip and, at voltages up to the break down voltage of the intact chips, can lead to a plasma being formed, with a very high power density. This results in the entire module being destroyed.

To avoid this problem, known from EP 0 989 611 B1 is a power semiconductor module which is formed from small-area individual chips and in which a short circuit of an individual chip does not lead to total failure of the module. According to this prior art, a metallic layer composed of a suitable material, for example, silver, is brought into direct contact with one or both of the main electrodes of the silicon semiconductor. The material of this metallic layer must form an eutectic mixture with silicon of the semiconductor. In the event of a short circuit, the entire sandwich structure is heated and, once the melting point of the eutectic mixture is reached, a conductive melt starts to form on the contact surface between the said metallic layer and the silicon. This zone can then expand over the entire thickness of the semiconductor, and thus form a metallically conductive channel which is also called hot spot. A sufficient electric contact is thereby provided by means of an electric contact piston.

Regarding the thickness of the metallic layer, the metallic layer must provide enough material to form the conductive channel through the whole thickness of the semiconductor. This is normally the case if the metallic layer has a thickness of at least 50% of the thickness of the semiconductor. In an ideal case, the ratio between the molar amount of material of the metallic layer and the molar amount of silicon should be approximately equal to the molar ratio of these materials at their eutectic point in the phase diagram so that the metallically conductive channel is formed of eutectic material.

However, under normal operating conditions at high power ratings that give rise to large temperature swings in the semiconductor devices, the introduction of the metallic layer in contact with the semiconductor raises the problem of thermo-mechanical fatigueunder intermittent operating load (IOL) and can result in fretting due to differences in the coefficients of thermal expansion (CTE) between the semiconductor chip and the metallic layer in contact. This could potentially result in early failure of the semiconductor chip.

Known from US 7,538,436 B2 is thus a high-power press-pack semiconductor module which comprises a layer, which is brought into direct contact with one or both of the main electrodes of the semiconductor chip, said layer being made of a metal matrix composite (MMC) material utilising two-dimensional, in the plane of the contact interface randomly oriented short graphite fibres, whose coefficient of thermal expansion can be tailored to a value either close to or matching that of silicon.

One of the major drawbacks of these semiconductor modules using contact pistons which apply pressure on the semiconductor device is their aging behaviour. In detail, there is the risk of silicone gel penetrating between the contacts leading to an increased ohmic resistance of the current path. This resistance is additionally increased by the number of the so formed dry contacts between the chip's electrode and the external electrical contact of the module. Their current load is furthermore limited by the spring shape. Furthermore, this kind of semiconductor modules is complex and cost intensive to manufacture.

### Summary of invention

It is therefore an object of the present invention to provide an improved power semiconductor module which shall obviate at least one of the disadvantages known in the art.

It is a further object of the present invention to provide an improved method of manufacturing a power semiconductor module which shall obviate at least one of the disadvantages known in the art.

In particular, it is an object of the present invention to provide a power semiconductor module and a method of manufacturing thereof in which the manufacturing method is easy to perform and in which the power semiconductor module has a good short circuit failure mode capacity and an improved reliability.

This object is achieved by a power semiconductor module according to claim 1. The object is furthermore achieved by a method of manufacturing a power semiconductor module according to claim 16. Preferred embodiments of the present invention are defined in the dependent claims.

The invention relates to a power semiconductor module, comprising a semiconductor device, in particular an insulated gate bipolar transistor (IGBT), a reverse conductive insulated gate bipolar transistor (RC IGBT), or a bi-mode insulated gate transistor (BIGT), with an emitter electrode and a collector electrode, wherein an electrically conductive upper layer connected to the emitter electrode by a sintered bond, a material of the upper layer is at least partly being capable of forming an eutecticum with the material of the semiconductor device and at least partly having a coefficient of thermal expansion which differs from the coefficient of thermal expansion of the semiconductor in a range of less than 250%(≤ 250%), in particular less than 50% (≤ 50%), and wherein an electrically conductive base plate is connected to the collector electrode by a further sintered bond, and wherein the semiconductor module further comprises an electrically conductive area being electrically insulated from the base plate and being connected to the upper layer via a direct electrical connection.

According to the invention, the upper layer comprises a suitable material with which the semiconductor device, or its emitter electrode, respectively, is brought in direct contact to by a sintering process. The material of this layer must form an eutecticum, or an eutectic mixture, respectively, with the semiconductor, especially with silicium. In the event of a short circuit, the entire sandwich structure is heated and, once the melting point of the eutectic mixture is reached, a conductive melt starts to form on the contact surface between said layer and the semiconductor. This zone can then expand over the entire thickness of the semiconductor, and thus form a metallically conductive channel. Consequently, the semiconductor module according to the invention provides a short circuit failure mode (SCFM)-capability.

The short circuit failure mode-capability according to the invention is thus based on melting of materials due to dissipation of energy induced by the failure. The silicon chip and a suitable metal part attached to its emitter contact, e.g. aluminium, gold, copper, or silver, melts and creates an electrically highly conductive alloy, the so called hot spot.

Due to the short circuit failure mode capability of the power semiconductor modules according to the invention, these modules may preferably be a component of voltage source converters (VSC) since they allow a high term reliable operation of said converters. In case of a short circuit, they are not able to switch anymore. However, they still may carry a load current. Mainly, there is redundancy in the system and the other modules are able to share the voltage, since the failed module has a function of resistor only. The converters, or semiconductor modules, respectively, then usually require only regular, planned maintenance to change failed modules.

Additionally, due to the fact that the upper layer has a coefficient of thermal expansion which differs from the coefficient of thermal expansion of the semiconductor in a range of ≤ 250%, in particular of ≤ 50%, the stress inside the semiconductor module, in particular between the upper layer and the semiconductor, may be reduced. This leads to the advantage that the risk of the internal stress inside the power module does not exceed an upper limit and thus the risk of cracks to be formed is reduced. This effect is of particular relevance if the semiconductor device is a high power semiconductor device, especially a high power insulated gate bipolar transistor. Consequently, the reliability of a power semiconductor module according to the invention is improved.

Due to the fact that the upper layer as well as the base plate is sintered to the semiconductor, or its electrodes, respectively, it is not necessary to provide dry contacts formed by a contact piston which exercises pressure onto the upper layer. The emitter electrode, or the upper layer, respectively, may thus be contacted by any connection which is appropriate for the desired application. As an example, the emitter electrode can be connected to a current lead by soldering, sintering, ultrasonic welding, transient bonding, and the like. Appropriately, the connections and the leads withstand the current load appearing in short circuit failure mode.

Additionally, the power semiconductor module comprises an electrically conductive area being electrically isolated or insulated from the base plate and being connected to the upper layer via a direct electrical connection. Thus, the emitter electrode, or the upper layer, respectively, is contacted via a direct electrical connection, i.e. a kind of bridge which directly proceeds from the upper layer to the electrically conductive area which in turn may be contacted according to the desired application.

Consequently, complex arrangements comprising complex current connections, or module power connections, especially in the upper housing of the semiconductor module, the contact pistons are connected to, may be omitted. Therefore, the power semiconductor module according to the invention may be manufactured in an easy manner. A bond may be realized directly on top of the power semiconductor device, or the upper layer, respectively.

The electrically conductive area may thus be used for providing interconnections to form an electric circuit and/or to cool the components. This is especially advantageous in the field of high power semiconductor modules, as they may carry high currents. They may preferably operate over a wide temperature range, especially up to 150 or 200°C, or even more.

An eutecticum, or an eutectic mixture, respectively, according to the invention, is thereby a mixture of chemical compounds, or elements, in particular of metals, that has a single chemical composition. Furthermore, and essentially, this single chemical composition has a melting point that lies at a temperature which is below the melting point, or melting region, respectively, of the different chemical compounds, or metals it is formed from. The eutecticum is thus essential to form the hot spot. With this regard, the upper layer forms the eutecticum particularly in case of a short circuit.

In a preferred embodiment of the present invention, the upper layer comprises at least two sublayers, wherein a lower sublayer is capable of forming an eutecticum with the semiconductor of the semiconductor device, and wherein an upper sublayer has a coefficient of thermal expansion which differs from the coefficient of thermal expansion of the semiconductor in a range of ≤ 250%, in particular of ≤ 50%. In this case, the upper layer is divided into two sublayers according to which the properties of the upper layer may be adapted to the desired application in a simple manner. In detail, the lower sublayer may be chosen to exactly form the desired eutecticum in case of a short circuit, whereas the upper sublayer may be chosen in dependence of the desired coefficient of thermal expansion of the semiconductor device. Consequently, a broad variety of possible configurations of the upper layer being exactly adaptable to the required application is possible. For example, there may be used cheaper material with suitable coefficient of thermal expansion as a buffer between a semiconductor chip and an emitter bond.

Even though there is no direct contact between the upper sublayer and the semiconductor device, it is anyhow important to provide an upper sublayer which has a coefficient of thermal expansion being adapted to that of the semiconductor. In detail, the upper sublayer is in close contact to the lower sublayer. Consequently, in case the lower sublayer is subjected to thermal expansion, or in contrast thereto, to contraction, this thermal behaviour is influenced by the upper sublayer. In detail, the expansion and/or contraction of the lower sublayer is influenced and thus adapted to the behaviour of the upper sublayer and thus of the semiconductor device by the upper sublayer. Consequently, due to the provision of the upper sublayer having a coefficient of thermal expansion being adapted to match the one of the semiconductor device, or semiconductor, respectively, the risk of getting internal damages, in particular cracks, is reduced. Therefore, a power semiconductor module according to the invention is improved with respect to reliability.

The lower and the upper sublayer may be sintered to each other thereby allowing sintering the two sublayers, or the upper layer, respectively, to the semiconductor device at one step. Alternatively, the two sublayers may be sintered to each other thereby forming a preform, which in turn is sintered to the semiconductor device.

It may be preferred, that the lower sublayer comprises aluminium, and/or that the upper sublayer comprises molybdenum. These compounds exhibit the desired properties. In detail, aluminium forms a suitable eutecticum with the semiconductor, the latter generally comprising silicium. Additionally, molybdenum has a coefficient of thermal expansion lying in the range of less than 200% more than that of silicium, in particular about 160% more than that of silicium.

In a further preferred embodiment of the present invention, the upper layer comprises a composite, in particular an aluminium-graphite composite. According to this embodiment, the semiconductor module according to the invention is particularly easy to prepare. The sublayer mainly comprises one compound which may be sintered to the semiconductor device. Therefore, preforming of two sublayers to form the upper layer, or to sinter three layers in one step is not required. In particular an aluminium-graphite composite has suitable properties with respect to the formation of an eutecticum as well as with respect to its coefficient of thermal expansion.

With this regard, the life time of the hot spot may be improved and furthermore the time which is required for forming a hot spot is reduced by adding of Al-skin on the surface of the Al-graphite part.

In a further preferred embodiment of the present invention, the base plate at least partly has a coefficient of thermal expansion which differs from the coefficient of thermal expansion of the semiconductor in a range of ≤ 250%, in particular ≤ 50%. This enables the stress inside the semiconductor module, in particular between the base plate and the semiconductor, to be reduced. Consequently, the risk of the internal stress inside the semiconductor module does not exceed an upper limit and thus the risk of cracks to be formed is reduced.

It is further preferred, that the base plate comprises molybdenum, copper-molybdenum, or aluminium-graphite. Especially molybdenum has a coefficient of thermal expansion lying in the range of less than 200% more than that of silicium, in particular about 160% more than that of silicium. Thus, the risks of cracks or damages in the internal structure of the power semiconductor module are minimized. Furthermore, it is electric conducting so that the semiconductor module according to the invention is suitable for a variety of applications.

In a further preferred embodiment of the present invention, the electrically conductive area is formed as a ceramic or metallic substrate, for example a direct bonded copper (DBC) substrate or active metal brazed (AMB) substrate. This substrate according to the invention particularly comprises a ceramic tile, in particular alumina (Al₂O₃), aluminium nitride (AIN), or beryllium oxide (BeO), with a sheet of a suitable metal, in particular of copper or aluminium, bonded to one or both sides. The usage of such a substrate according to the invention is advantageous because of its very good thermal conductivity. A further main advantage of such a substrate is its low coefficient of thermal expansion, which is close to that of the semiconductor, in particular silicium, especially compared to pure metal. This ensures good thermal cycling performances. They also have excellent electrical insulation and good heat spreading characteristics. Current capability of a metallic layer of a substrate can be improved by bonding of an additional electrically highly conductive part or layer with a matching coefficient of thermal expansion to it, for example, made of molybdenum, aluminium graphite or copper-molybdenum

In a further preferred embodiment of the present invention, at least two semiconductor devices are sintered to one base plate, the emitter electrodes of which are connected to one electrically conductive area. This allows a variety of even complex internal structures to be formed resulting in a variety of suitable applications of the power semiconductor module.

It is furthermore preferred that the electrically conductive area and/or the upper layer and/or the base plate is contacted by a contact piston. With this regard, the contact piston particularly provides an external contact of the electrically conductive area. Even if the provision of a contact piston is not strictly required, it may be advantageous to provide the external contacts with the piston. This particularly allows a vertical path of electric current for an external contact with a high amount of current flowing through the piston. As an example, it is possible to guide a much higher current through a piston compared to bonds, like wire bonds, for example. Due to the fact that the contact piston is not required to form a dry contact between the respective layers, high pressures are not required. The reliability is thus not decreased.

In a further preferred embodiment, the electrically conductive area is contacted by an external terminal, and the base plate is contacted by an external terminal. This embodiment provides a simple and cost-saving electrical contact to an external contact device. The terminal may be formed of a suitable metal plate, for example.

In a further preferred embodiment of the present invention, the electrical connection is bonded by soldering or welding. This is an especially easy and reliable connection, thereby not requiring a contact piston.

In a further preferred embodiment of the present invention, the base plate is electrically conductive and has preferably a contact surface on the opposite side of the power semiconductor (12), which contact surface is in direct electrical contact to the sintered bond. This electrically conductive base plate allows stacking a plurality of modules. By stacking the modules the upper contact of the lower module, which is the emitter contact of the module, contacts the lower contact of the upper module, which is the collector contact of the module.

The invention furthermore relates to a method of manufacturing a power semiconductor module, comprising: providing a semiconductor device, in particular an insulated gate bipolar transistor, a reverse conductive insulated gate bipolar transistor, or a bi-mode insulated gate transistor, having an emitter electrode and a collector electrode, sintering an electrically conductive upper layer to the emitter electrode, the upper layer at least partly being capable of forming an eutecticum with the semiconductor of the semiconductor device and at least partly having a coefficient of thermal expansion which differs from the coefficient of thermal expansion of the semiconductor in a range of ≤ 250%, in particular ≤ 50%, sintering an electrically conductive base plate to the collector electrode, providing an electrically conductive area on the base plate such, that the electrically conductive area is electrically insulated from said base plate and is connected to the upper layer via a direct electrical connection.

According to the above, a power semiconductor module according to the invention is easily performed leading to the advantages described above with respect to the power semiconductor module according to the invention.

### Brief description of drawings

Additional features, characteristics and advantages of the subject-matter of the invention are disclosed in the subclaims, the figures and the following description of the respective figures and examples, which -in an exemplary fashion- show one embodiment and example of a semiconductor module according to the invention.

### In the figures:

Figure 1 shows a partial sectional side view of a part of an embodiment of a power semiconductor module according to the invention;

Figure 2 shows a partial sectional side view of an embodiment of a power semiconductor module according to the invention;

Figure 3 shows a partial sectional side view of a further embodiment of a power semiconductor module according to the invention.

### Description of embodiments

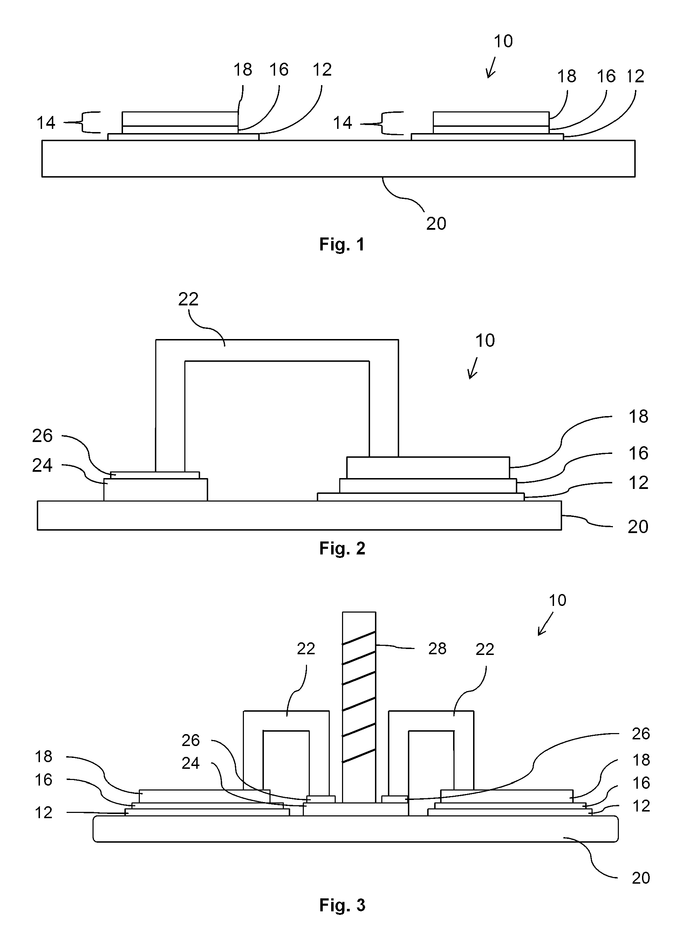

In figure 1, a part of an arrangement of a power semiconductor module 10 according to the invention is schematically shown. In detail, the semiconductor module 10 comprises a power semiconductor chip, or power semiconductor device 12, respectively. The semiconductor device 12 may in an exemplary manner be an insulated gate bipolar transistor (IGBT), a reverse conductive insulated gate bipolar transistor (RC IGBT), a bi-mode insulated gate transistor (BIGT), a diode, a metal oxide semiconductor field-effect transistor (MOSFET), or the like. According to the invention, the semiconductor device 12 is designed for forming a power semiconductor module, or high power semiconductor module, respectively thus being particularly suitable for high power applications in which high amounts of electric currents are used. The semiconductor device 12 comprises an emitter electrode, or anode, respectively at its upper side and a collector electrode, or cathode, at its lower side. More generally, the emitter electrode forms a load connection of the semiconductor device 12 and the collector electrode forms a further load connection of the semiconductor device 12. Further, the semiconductor device 12 may comprise a gate electrode or the like for controlling the semiconductor device.

An upper layer 14 is sintered to the semiconductor device 12, or the emitter (anode) electrode, respectively. Thus the upper layer 14 is connected to the emitter electrode by a sintered bond. As an example, the upper layer 14 may be sintered to the semiconductor device 12 by a low-temperature bonding, silver nanosintering process, or the like.

The upper layer 14 is at least partly capable of forming an eutecticum with the semiconductor of the semiconductor device 12. In other words, the upper layer 14 comprises a material being capable of forming an eutecticum with the semiconductor device 12. In particular, the respective semiconductor device 12 comprises silicon. The upper layer 14 furthermore has at least partly a coefficient of thermal expansion which differs from the coefficient of thermal expansion of the semiconductor in a range of ≤ 250%, in particular of ≤ 50%. This may be realized in different ways.

As an example, the upper layer 14 may comprise at least two sublayers. According to figure 1, the upper layer 14 comprises a lower sublayer 16 and an upper sublayer 18. With this regard, it is especially preferred that the lower sublayer 16 is capable of forming an eutecticum with the material of the semiconductor device 12, especially with silicon. Therefore, the lower sublayer 16 may be formed of aluminium, silver, gold or copper. Further, alloys of the mentioned metals may also be possible. The upper sublayer 18 thereby has a coefficient of thermal expansion which differs from the coefficient of thermal expansion of the semiconductor in a range of ≤ 250%, in particular of ≤ 50%. This may be realized by forming the upper sublayer 18 of molybdenum. However, the lower sublayer 16 as well as the upper sublayer 18 may be formed of any material suitable and exhibiting the required properties.

In order to be able to form a conductive channel of eutecticum through the semiconductor device 12, the upper layer 14 must provide enough material to form such a channel. For this, the thickness of the upper layer 14 or of the lower sublayer 18 respectively, should be at least 50 % of the thickness of the semiconductor device 12 and/or should have a thickness of at least 0.1 mm, more preferable of at least 0.5mm and most preferably of at least 0.8mm. Actually, the thickness of the upper layer 14 or the lower sublayer 18 depends on the thickness of the semiconductor device, which again depends on the electric specification, i.e. on the blocking voltage of the semiconductor device 12. The lower sublayer 16 and the upper sublayer 18 may be provided as a preform. The thickness of the preforms are typically in the range of 0.2mm to 5mm. Therefore, they may be connected by a sintering process, for example. In a further step, for manufacturing a power semiconductor module 10 according to the invention, the preform may be sintered to the semiconductor device 12, or to the emitter side, or emitter electrode, of the semiconductor device 12, respectively. Alternatively, the lower sublayer 16 and the upper sublayer 18 may be sintered together and sintered to the semiconductor device 12 in one step. It is also possible to connect the lower sublayer 16 to the upper sublayer 18 by a different technique like laminating, brazing or roll cladding.

In an alternative embodiment, the upper layer 14 may mainly comprises one component. In this case, it is mostly preferred that the main component comprises a composite material. The upper layer 14 may be formed of e.g. an aluminium-graphite composite. This compound has the desired properties with respect to the formation of an eutecticum and with respect to the coefficient of thermal expansion. Another example as main component for the upper layer 14 comprises an aluminium-molybdenum-aluminium (Al-Mo-Al)-laminate.

Additionally, a base plate 20 is sintered to the semiconductor device 12, or to its collector side, or collector electrode (cathode), respectively. Thus a sintered bond between the base plate 20 and the semiconductor device 12 is formed. For example, a sintering process like described above may be used. The base plate 20 preferably has a coefficient of thermal expansion which differs from the coefficient of thermal expansion of the semiconductor in a range of ≤ 250%, in particular of ≤ 50%. This may be realized by forming the base plate 20 of molybdenum, a copper-molybdenum alloy, or an aluminium-graphite composite, for example. Further, the base plate 20 is electrically conductive. In particular, the surface of the base plate 20 opposite of the surface of the base plate 20 on which the semiconductor device 12 is connected by the sintered bond forms a contact surface for contacting the power semiconductor module 10. The contact surface of the base plate 20 is thus in direct electrical contact to the sintered bond.

The base plate 20 serves as a base or as a support of the module.

The emitter electrode contact formed by the upper layer 14 may then be contacted by a suitable technique, for example by ultrasound welding, sintering, soldering, or the like. Thereby, a connection should be formed which can withstand the failure event and the required current load afterwards.

An example for such a structure is shown in figure 2. According to figure 2, in a non limiting example, the upper layer 14 comprises a lower sublayer 16 as well as an upper sublayer 18 to obtain the required properties with respect to coefficient of thermal expansion as well as formation of an eutecticum.

In detail, the emitter electrode is contacted via an electrical connection 22, preferably a high current connection, to an electrically conductive area 24, the latter being electrically insulated from the base plate 20. The electrically conductive area 24 may preferably be a direct bonded copper substrate (DBC-substrate), for example. The electrical connection 22 may be formed of copper, molybdenum, or an alloy of molybdenum and copper, for example and should withstand currents of at least 50A and/or of up to 2000A, or more, and/or temperatures of 200°C, or more. A contact layer 26, in particular a highly conductive layer, which may be formed of molybdenum, aluminium-graphite, copper-molybdenum, copper, gold, silver or alloys thereof may be arranged as an interface between the electrically conductive area 24 and the electrical connection 22 in order to improve the current capability of the metallic layer of the substrate. Preferably, the contact layer 26 has a coefficient of thermal expansion matching the one of the metallic layer of the substrate.

Further, the electrically conductive area 24 and/or the contact layer 26 are arranged on the same side of the base plate 20 as the semiconductor device 12.

A power semiconductor module 10 according to the invention has thus a suitable short circuit failure mode capability, which may be realized by the heat-induced formation of a hot spot, the semiconductor module 10 according to the invention thus being very reliable.

A method of manufacturing a power semiconductor module 10, thus comprises: providing a semiconductor device 12, in particular an insulated gate bipolar transistor, a reverse conductive insulated gate bipolar transistor, or a bi-mode insulated gate transistor, having an emitter electrode and a collector electrode, sintering an electrically conductive upper layer 14 to the emitter electrode, the upper layer 14 at least partly being capable of forming an eutecticum with the semiconductor of the semiconductor device 12 and at least partly having a coefficient of thermal expansion which differs from the coefficient of thermal expansion of the semiconductor in a range of ≤ 250%, in particular ≤ 50%, sintering an electrically conductive base plate 20 to the collector electrode, the base plate 20 preferably at least partly having a coefficient of thermal expansion which differs from the coefficient of thermal expansion of the semiconductor in a range of ≤ 250%, in particular ≤ 50%, providing an electrically conductive area 24 on the base plate 20 such, that the electrically conductive area 24 is electrically insulated from said base plate 20 and is connected to the upper layer 14 via a direct electrical connection 22.

In figure 3, a further embodiment of the present invention is shown. According to figure 3, two semiconductor devices 12 are sintered on one base plate 20, the emitter electrodes of which are connected to one electrically conductive area 24. A so formed sub-module allows providing complex internal structures for high power applications.

Preferably, the electrically conductive area 24 and/or the upper layer, or the emitter electrode, respectively, is contacted by a contact piston 28. Consequently, although high pressure on the surface of the semiconductor device 12 is not necessary for forming dry contacts according to the invention due to the sintering connection of the respective layers, it is still possible to provide a kind of press-pack design of the semiconductor module 10.

A possible arrangement may provide a small number of contact pistons 28, or springs, respectively, in the centre of each submodule in that the contact pistons 28 are directly bonded to electrical leads, to the electrically conductive area 24 or to the contact layer 26. An alternative arrangement may comprise one contact piston 28 in each of the corners of the semiconductor module 10, wherein again the contact pistons 28 are directly bonded to electrical leads, to the electrically conductive area 24 or to the contact layer 26.

Instead of the contact pistons 28, it is possible to directly provide one or more conventional external terminals for external contacting the semiconductor device 12, or the submodule, respectively, or the electrically conductive area 24 and the base plate.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope

### Reference signs list

- 10: semiconductor module
- 12: semiconductor device
- 14: upper layer
- 16: lower sublayer
- 18: upper sublayer
- 20: base plate
- 22: electrical connection
- 24: electrically conductive area
- 26: contact layer
- 28: contact piston

## Claims

1. Power semiconductor module comprising a semiconductor device (12), in particular an insulated gate bipolar transistor, a reverse conductive insulated gate bipolar transistor, or a bi-mode insulated gate transistor, with an emitter electrode and a collector electrode, wherein an electrically conductive upper layer (14) is connected to the emitter electrode by a sintered bond, a material of the upper layer (14) is at least partly being capable of forming an eutecticum with the material of the semiconductor device (12) and the upper layer (14) is at least partly having a coefficient of thermal expansion which differs from the coefficient of thermal expansion of the semiconductor device in a range of ≤ 250%, in particular ≤ 50%, and wherein an electrically conductive base plate (20) is connected to the collector electrode by a further sintered bond, and wherein the power semiconductor module (10) further comprises an electrically conductive area (24) being electrically insulated from the base plate (20) and being connected to the upper layer (14) via a direct electrical connection (22).

2. Power semiconductor module according to claim 1, wherein the upper layer (14) comprises at least two sublayers, wherein a lower sublayer (16) is capable of forming an eutecticum with the semiconductor of the semiconductor device (12), and wherein an upper sublayer (18) has a coefficient of thermal expansion which differs from the coefficient of thermal expansion of the semiconductor in a range of ≤ 250%, in particular ≤ 50%.

3. Power semiconductor module according to claim 2, wherein the lower sublayer (16) comprises aluminium, silver, gold or copper, and/or wherein the upper sublayer (18) comprises molybdenum and/or wherein the thickness of the lower sublayer (18) is at least 50% of the thickness of the semiconductor component (12) .

4. Power semiconductor module according to claim 1, wherein the upper layer (14) comprises a composite material, in particular an aluminium-graphite composite or a aluminium-molybdenum-aluminium laminate.

5. Power semiconductor module according to one of the claims 1 to 4, wherein the thickness of the upper layer (14) is at least 50% of the thickness of the semiconductor device (12) and/or has a thickness of at least 0.05mm, more preferably of at least 0.2mm and most preferably of at least 0.3mm.

6. Power semiconductor module according to any of claims 1 to 4, wherein the base plate (20) at least partly has a coefficient of thermal expansion which differs from the coefficient of thermal expansion of the semiconductor in a range of ≤ 250%, in particular ≤ 50%,

7. Power semiconductor module according to claim 5, wherein the base plate (20) comprises copper, molybdenum, copper-molybdenum or aluminium-graphite.

8. Power semiconductor module according to any of claims 1 to 6, wherein the electrically conductive area (24) is formed as a direct bonded copper substrate or an active metal brazed substrate.

9. Power semiconductor module according to any of claims 1 to 7, wherein at least two semiconductor devices (12) are sintered to one base plate (20), the emitter electrodes of which are connected to one electrically conductive area (24).

10. Power semiconductor module according to any of claims 1 to 8, wherein the electrically conductive area (24) and/or the upper layer (14) and/or the base plate is contacted by a contact piston.

11. Power semiconductor module according to any of claims 1 to 9, wherein the electrically conductive area (24) is contacted by an external terminal, and the base plate (20) is contacted by an external terminal.

12. Power semiconductor module according to any of claims 1 to 10, wherein the electrical connection (22) is bonded by soldering or welding or sintering.

13. Power semiconductor module according to one of the claim s 1 to 11, wherein the base plate (20) is electrically conductive and has preferably a contact surface on the opposite side of the power semiconductor (12), which contact surface is in direct electrical contact to the sintered bond.

14. Power semiconductor module according to one of the claims 1 to 12, wherein the semiconductor device (12) and the electrically conductive area (24) are arranged on the same side of the base plate (20).

15. Power semiconductor module according to any of the claims 1 to 13, wherein the semiconductor module provides a short circuit failure mode capability.

16. Method of manufacturing a power semiconductor module (10), comprising:
- providing a semiconductor device (12), in particular an insulated gate bipolar transistor, reverse conductive insulated gate bipolar transistor, or bi-mode insulated gate transistor, having an emitter electrode and a collector electrode,
- sintering an electrically conductive upper layer (14) to the emitter electrode, the upper layer (14) at least partly being capable of forming an eutecticum with the semiconductor of the semiconductor device (12) and at least partly having a coefficient of thermal expansion which differs from the coefficient of thermal expansion of the semiconductor in a range of ≤ 250%, in particular ≤ 50%,
- sintering an electrically conductive base plate (20) to the collector electrode,
- providing an electrically conductive area (24) on the base plate (20) such, that the electrically conductive area (24) is electrically insulated from said base plate (20) and is connected to the upper layer (14) via a direct electrical connection (22).
